Europäisches Patentamt

European Patent Office

Office européen des brevets

(11) Publication number: **0 410 635 A1**

# (12) EUROPEAN PATENT APPLICATION

(21) Application number: 90307848.3

(22) Date of filing: 18.07.90

(51) Int. Cl.5: **H01L 21/302**, H01L 21/311

(30) Priority: 28.07.89 US 387254

(43) Date of publication of application:
30.01.91 Bulletin 91/05

(84) Designated Contracting States:
DE ES FR GB

(71) Applicant: AMERICAN TELEPHONE AND
TELEGRAPH COMPANY
550 Madison Avenue
New York, NY 10022(US)

(72) Inventor: Chew, Hongzong
2859 Edgemont Drive
Allentown, Pennsylvania 18103(US)
Inventor: Fieber, Catherine Ann
R.D. No. 1, Box 41
Emmaus, Pennsylvania 18049(US)
Inventor: Hills, Graham William
1101 Flexer Avenue
Allentown, Pennsylvania 18103(US)
Inventor: Martin, Edward Paul, Jr.
493 Greenwood Avenue
Bethlehem, Pennsylvania 18017(US)

(74) Representative: Johnston, Kenneth Graham et
al
AT&T (UK) LTD. AT&T Intellectual Property
Division 5 Mornington Roadoadoad
Woodford Green Essex, IG8 OTU(GB)

(54) Window taper-etching method in the manufacture of integrated circuit semiconductor devices.

(57) In a two-step etching process for making tapered contact openings in a dielectric (11), a thin layer of a material (12) is interposed to serve as an adhesive between the dielectric and a photoresist layer (13); such material is chosen to remain essentially intact during undercut partial etching of the dielectric. As a result of enhanced adhesion, the photoresist layer remains more accurately positioned for subsequent isotropic etching across the remainder of the thickness of the dielectric.

FIG. 4

# WINDOW TAPER-ETCHING METHOD IN THE MANUFACTURE OF INTEGRATED-CIRCUIT SEMICONDUCTOR DEVICES

Technical Field

The invention is concerned with electrical contacts and interconnections in the manufacture of integrated-circuit semiconductor devices, involving etching of windows in a dielectric.

Background of the Invention

In the manufacture of integrated-circuit semiconductor devices, involving numerous operations including dopant-ion implantation, dielectric and metallic layer deposition, and photolithographic pattern definition and etching, it is desirable to produce etched openings or windows in dielectric layers having sloping or tapered profiles. Resulting openings may be intended for at least partial filling with a conductor material such as, e.g. aluminum, and sloping of profiles is largely in the interest of facilitating surface coverage by such material.

One method for making tapered openings, disclosed by M.P. Karnett, "Tapered Wet Etching of Contacts Using a Trilayer Silox Structure", SPIE, Vol. 772 (1987), pp. 166-171 involves etching of a three-layer structure deposited by chemical-vapor deposition, with a middle layer of phosphosilicate glass. Another familiar method uses twin etching steps, namely a step of wet etching so that a photoresist pattern is undercut, followed by a step of reactive-ion etching using the same photoresist pattern to further etch the dielectric straight through the remainder of its thickness.

One concern arising with methods involving wet etching of dielectric material arises with the tendency of photoresist material to separate from the dielectric in the course of etching, and the invention as described below is motivated by the desire for guarding against such tendency.

According to the present invention there is provided a method as defined in claim 1.

In a two-step etching process for making tapered contact or interconnection openings in a dielectric, a thin layer of a material is interposed to serve as an adhesive between the dielectric and a photoresist layer; such material is chosen to remain substantially intact during undercut partial etching of the dielectric. As a result of enhanced adhesion, the photoresist layer remains more accurately positioned for subsequent anisotropic etching across the remainder of the thickness of the dielectric.

Preferred processing in accordance with the invention is particularly applicable to devices having design-rule feature size less than 3 micrometers, and especially to structures comprising contact openings which are spaced apart, center to center, by less than 5 micrometers.

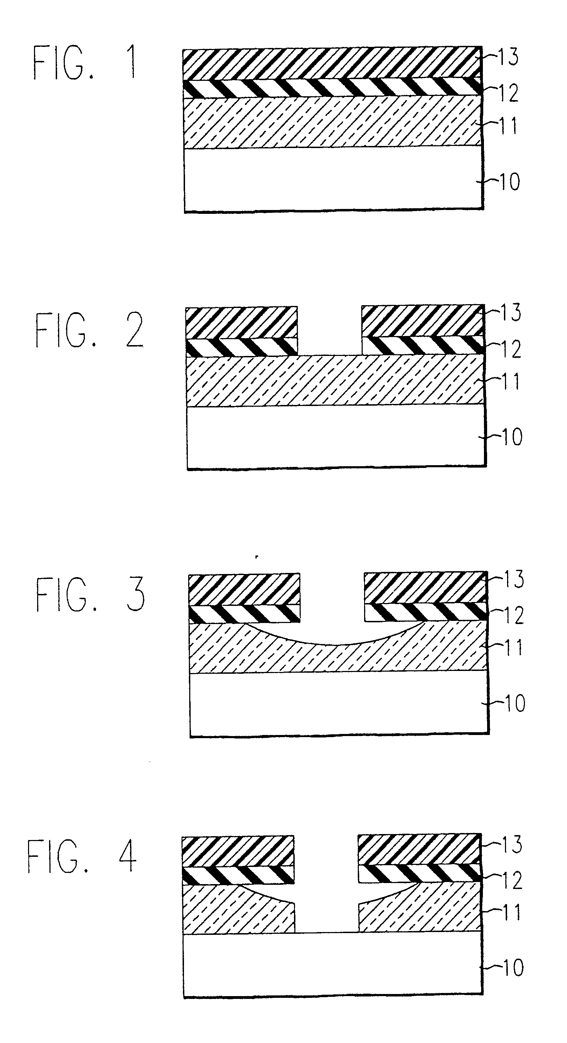

FIGS. 1-4 are schematic cross-sectional views of an integrated-circuit semiconductor device at sequential stages of exemplary processing in accordance with the invention. For the sake of ease of representation and appreciation dimensions are not to scale.

With reference to the Figures, an exemplary preferred embodiment of the invention involves structures and processing as follows:

FIG. 1 shows substrate 10 with dielectric material 11 to be etched, and additional layers 12 and 13 on the dielectric material, layer 13 being a photoresist layer, and layer 12 being interposed between dielectric 11 and layer 13 for the sake of enhanced adhesion of layer 13. The material of layer 12 is chosen such that it remains essentially unaffected by an etchant used for etching dielectric 11. In this respect, for example, when dielectric 11 consists essentially of silicon dioxide, and if a fluorocarbon chemistry is used for etching, polycrystalline silicon, amorphous silicon, or silicon nitride are suitable as layer-12 materials, typically approximately 100 to 200 angstroms thick. Conveniently, low-pressure chemical vapor deposition or plasma-enhanced chemical vapor deposition can be used for silicon or silicon nitride; also, for silicon, sputtering may be used.

FIG. 2 shows the structure of FIG. 1 after patterning of photoresist layer 13 and reactive ion etching of layer 12, so as to uncover sites of contact openings, the diameter of openings being greater than or (more typically) equal to a design-rule limit.

FIG. 3 shows the structure of FIG. 2 after partial etching into dielectric 11 by isotropic etching so as to undercut the photoresist layer 13 as well as unetched portions of layer 12. Due to undercutting, the diameter of the etched portion will be larger than the design-rule limit; for example, in the case of a 1.5-micrometer contact, such diameter may typically be about 2.3 micrometers (i.e. there is a 0.4-micrometer increase per side).

FIG. 4 shows the structure of FIG. 3 after further, ansiotropic etching across the remainder of the thickness of layer 11, thereby completing the production of a desired opening. Then, in preparation for the deposition of a conductor material such as, e.g. aluminum or tungsten, photoresist layer 13 is stripped, and layer 12 is removed also.

With respect to materials included in structures undergoing processing substrate 10 may be a body of semiconductor material which may be n- or p-doped at least at the point windows. Also, substrate 10 may included conductor layers as made, e.g., of a conductive silicide or of a metal, on semiconductor or dielectric material. Etched openings may be intended for electrical interconnection between metallization levels. Dielectric layer 11 may be essentially conformal to substrate 10; alternative layer 11 may vary in thickness as produced, e.g., by planarization processing of a conformally deposited layer.

Layer 12, in addition to serving as an adhesion layer, may further serve as an antireflection layer, i.e., for the sake of preventing or minimizing unwanted reflections of actinic radiation during photoresist exposure. On silicon dioxide, the inclusion either of silicon or of silicon nitride as layer-12 material is beneficial in this respect as well. As antireflection consideration may arise also in the absence of concerns with adhesion between layers 11 and 13, it is important that an antireflection layer be chosen so as to maintain adequate adhesion of layer 13. For example, when dielectric 11 consists essentially of silicon nitride, concerns with adhesion of photoresist layer 13 are alleviated. Still, inclusion of an antireflection layer may be indicated, in which case attention is due the adhesion properties of the antireflection-layer material. In this case, silicon represents a suitable choice with respect to antireflection as well as adhesion functions.

The method is applicable to dielectric materials yet other than silicon dioxide or silicon nitride; in particular, application to silicon oxynitride and to aluminum oxide is contemplated. Furthermore, the method may be of interest in the case of borosilicate, phosphosilicate, or borophosphosilicate dielectrics. And, as layer-12 materials other than silicon and silicon nitride, titanium nitride, titanium oxide, titanium oxynitride, and titanium-tungsten may be chosen.

## Claims

1. In the manufacture of integrated-circuit semiconductor devices, a method for etching an opening with sloping or tapered profile in dielectric material, said opening being etched in the presence of a patterned photoresist layer, CHARACTERISED IN THAT the etching is effected in the presence of an additional patterned layer selected to at least provide adhesion between the photoresist layer and the dielectric, and in that the said etching comprises a first step of isotropic etching and a second step of substantially anisotropic etching, the material of said additional layer being substantially unaffected in the course of said etching.

2. The method of claim 1, CHARACTERISED IN THAT said dielectric comprises a material selected from the group consisting of silicon dioxide, silicon nitride, silicon oxynitride, aluminum oxide, borosilicate glass, phosphosilicate glass, and borophosphosilicate glass.

3. The method of claim 1 or 2, CHARACTERISED IN THAT said additional layer comprises a material selected from the group consisting of silicon, silicon nitride, titanium nitride, titanium oxide, titanium oxynitride, and titanium-tungsten.

4. The method of claim 3, CHARACTERISED IN THAT said additional layer has a thickness in the range from 100 to 200 angstroms.

5. The method of claim 1, CHARACTERISED IN THAT said dielectric comprises silicon dioxide, and in that a fluorocarbon chemistry is used for anisotropic etching.

6. The method of claim 1, CHARACTERISED IN THAT substantially anisotropic etching is effected by reactive-ion etching.

7. The method of claim 1, CHARACTERISED IN THAT integrated-circuit design rule is less than or equal to 3 micrometers.

8. The method of claim 1, CHARACTERISED IN THAT contact spacing pitch is less than or equal to 5 micrometers.

9. The method of claim 1, CHARACTERISED IN THAT said dielectric material is an conformally deposited, or has been planarized.

10. The method of claim 1, CHARACTERISED IN THAT said contact is to semiconductor material, or to a conductor material.

FIG. 1

FIG. 2

FIG. 3

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 127 946 (BRITISH TELECOMMUNICATIONS) <br> * page 2, line 27 - page 3, line 6; page 5, line 11 - page 6, line 15; page 7, lines 14-16; claims 2,4; figure 2 * <br> — — — | 1,7-10 | H 01 L 21/302 <br> H 01 L 21/311 |
| Y | | 2,3,5,6 | |
| Y | PATENT ABSTRACTS OF JAPAN <br> vol. 6, no. 132 (E-119)(1010), 17 July 1982; & JP-A-57058321 (TOKYO SHIBAURA DENKI K.K.) 08.04.1982 * abstract; figures A,B * <br> — — — | 2,3 | |
| A | idem <br> — — — | 1,9,10 | |
| Y | EP-A-0 030 116 (FUJITSU LTD.) <br> * page 5, lines 5-38; page 7, line 33 - page 8, line 33; page 15, lines 8-21; table 2-2; figures 6-8 * <br> — — — | 5,6 | |
| A | | 1,2,9,10 | |
| X | US-A-4 495 220 (S. WOLF et al.) <br> * column 3, line 26 - column 4, line 38; column 4, line 58 - column 5, line 2; figures 1a-e * <br> — — — | 1,9,10 | |
| A | | 6 | **TECHNICAL FIELDS SEARCHED (Int. Cl.5)** |
| X | US-A-4 560 436 (Y. BUKHMAN et al.) <br> * column 3, line 4 - column 4, line 24; column 4, lines 40-45; figures 1-4 * <br> — — — | 1,9,10 | H 01 L |
| A | | 4-6 | |
| A | EP-A-0 188 735 (IBM) <br> * column 2, line 6 - column 3, line 4; column 3, lines 48-60; figures 1A-D * <br> — — — | 1-3,5,6,9,10 | |
| A | EP-A-0 287 096 (TOSHIBA K.K.) <br> * page 3, line 40 - page 4, line 14; figures 1A-C * <br> — — — — — | 1,2,5-7,9,10 | |

The present search report has been drawn up for all claims

| Place of search | Date of completion of search | Examiner |
|---|---|---|
| Berlin | 28 September 90 | KLOPFENSTEIN P R |